# EUROPÄISCHE PATENTSCHRIFT

(11) **EP 3 899 992 B1**
(45) Veröffentlichungstag und Bekanntmachung des Hinweises auf die Patenterteilung: **25.01.2023**
(21) Anmeldenummer: 19836494.5
(22) Anmeldetag: 20.12.2019
(51) Int. Cl.: H01F 7/02, H01F 10/12, H01F 41/16, G02B 26/08, B81B 5/00

(54) **MEMS-SYSTEM**
MEMS SYSTEM
MICROSYSTÈME ÉLECTROMÉCANIQUE

(30) Priorität: 21.12.2018 DE 102018222845
(43) Veröffentlichungstag der Anmeldung: 27.10.2021
(73) Patentinhaber: Fraunhofer-Gesellschaft zur Förderung der angewandten Forschung e.V., 80686 München (DE)
(72) Erfinder: NIEKIEL, Malte Florian, 25524 Itzehoe (DE); LOFINK, Fabian, 25524 Itzehoe (DE); LISEC, Thomas, 25524 Itzehoe (DE)
(74) Vertreter: Pfitzner, Hannes
(86) Internationale Anmeldenummer: PCT/EP2019/086755
(87) Internationale Veröffentlichungsnummer: WO 2020/128018

(56) Entgegenhaltungen:
- EP-A1- 1 925 008
- EP-A2- 2 492 646
- US-A1- 2008 202 258
- LISEC ET AL: "A novel technology for MEMS based on the agglomeration of powder by atomic layer deposition", 19TH INTERNATIONAL CONFERENCE ON SOLID-STATE SENSORS, ACTUATORS AND MICROSYSTEMS, 18. Juni 2017 (2017-06-18), Seiten 427-430, XP033130788, DOI: 10.1109/TRANSDUCERS.2017.7994078 [gefunden am 2017-07-26]
- LIAKOPOULOS ET AL: "MICROMACHINED THICK PERMANENT MAGNET ARRAYS ON SILICON WAFERS", IEEE INTERNATIONAL MAGNETICS CONFERENCE, 9. April 1996 (1996-04-09), Seite HD/07, XP000769551, ISBN: 978-0-7803-3241-6

## Beschreibung

Ausführungsbeispiele der vorliegenden Erfindung beziehen sich auf ein MEMS-System sowie auf ein entsprechendes Herstellungsverfahren. Beansprucht ist ein MEMS-System mit zwei permanentmagnetischen Mikrostrukturen, deren magnetische Kopplung zur Kraftübertragung genutzt wird.

Nahezu alle mikromechanischen Systeme basieren auf der Erzeugung mechanischer Kräfte (Aktoren) oder deren Umwandlung in elektrische Signale (Sensoren). Die etablierten Antriebskonzepte erlauben eine effektive Krafterzeugung bzw. -übertragung entweder in der Bauteil-Ebene (lateral) oder senkrecht dazu (vertikal). Ein elektrostatischer Kammantrieb eignet sich z. B. für die laterale Krafterzeugung, während ein piezoelektrischer Biegebalken für vertikale Auslenkungen angewendet werden kann. Diese Konzepte lassen sich nicht oder nur sehr schwer auf die jeweils andere Richtung übertragen. So ist z.B. ein Kammantrieb mit vertikalen Fingern oder ein lateraler Piezo-Biegeaktuator mit den bestehenden technologischen Prozessen kaum realisierbar. Ähnliche Beispiele lassen sich auf dem Gebiet der Sensorik finden, wo unterschiedliche Detektionsmechanismen in verschiedene Richtungen unterschiedlich gut funktionieren. Das schränkt die Anwendungsmöglichkeiten mikroelektromechanischer Systeme (MEMS) erheblich ein. Es wäre daher äußerst attraktiv, Auslenkungen und/oder Kräfte in MEMS effektiv in beliebige Richtungen transformieren zu können.

In MEMS kommen vor allem elektrostatische und piezoelektrische Antriebe zum Einsatz. Die Wirkrichtung der Kraft bzw. Auslenkung ist dabei grundsätzlich durch die Geometrie des Antriebs vorgegeben. So wurden beispielsweise für elektrostatische Aktoren verschiedene Geometrien entwickelt, um verschiedene Wirkrichtungen abzudecken. So sind laterale Kammantriebe [1], vertikale Kammantriebe [2], kippende Kammantriebe [3], rotierende Kammantriebe [4] und Parallelplattenantriebe [5, 6] bekannt. Obwohl sie alle auf demselben physikalischen Effekt beruhen, der elektrostatische Anziehung bzw. Abstoßung zweier Elektrodenflächen, fällt der Effekt jedoch sehr unterschiedlich aus. Der laterale Kammantrieb ermöglicht z. B. große Auslenkungen von über 100 µm dank langer Fingerelektroden [7]. Beschränkt durch die planaren Fertigungsprozesse der Halbleitertechnologie ist die Auslenkung vertikaler, kippender oder rotierender Kammantriebe um eine Größenordnung geringer. Piezoelektrische Antriebe, die zumeist auf Biegebalken beruhen, sind hingegen vor allem für vertikale Auslenkungen oder Verkippungen gut geeignet. Laterale piezoelektrische Antriebe sind in diesem Fall nur schwer realisierbar.

Bisherige Versuche, die Wirkrichtungen in mikroelektromechanischen Systemen zu ändern und/oder die Kraft oder Auslenkung zu verstärken, basieren größtenteils auf mechanischen Hebelstrukturen. Anzuführen sind hier z. B. ausbeulende Strukturen zur Auslenkungsverstärkung von Antrieben [8, 9], aber auch optimierte Hebelsysteme, wie sie zur Steigerung der Sensitivität von Beschleunigungssensoren Anwendung finden [10, 11]. Bei diesen Beispielen verbleibt die Wirkrichtung in der Bauteil-Ebene. Es finden sich aber auch vertikal wirkende Hebelstrukturen. In [12] wird die vertikale Auslenkung eines kippenden Kammantriebs durch eine Hebelstruktur auf einen Mikrospiegel übertragen. Eine weitere Form der Kraft/Auslenkungs-Umwandlung sind Mikrogetriebe basierend auf Si-Zahnrädern [13]. Deren praktische Anwendung scheitert jedoch am außerordentlich schnellen Verschleiß aufgrund von Reibung. Zu erwähnen sind noch mechanische Bandpassfilter, basierend auf gekoppelte Schwingkörpern. Die Kopplung zur Übertragung der Kräfte zwischen den schwingenden Massen wird bevorzugt über mechanische Federn gelöst [14, 15], seltener auch über eine elektrostatische Kraftkopplung [16].

Die Übertragung von Kräften oder Auslenkungen von einem externen Antrieb in ein Mikromechanisches System hinein wird z. B. kontaktmechanisch gelöst. In [17] wird der vertikale Hub eines Steppermotors in einem haptischen Display angewendet. [18] beschreibt einen piezoelektrischen Harvester, in dem ein MEMS-Biegewandler mittels eines Zahnrads direkt mechanisch betätigt wird. All diese Wandlungen ziehen erheblichen Reibungsverschleiß aufgrund des direkten Kontakts der mikromechanischen Strukturen mit konventionell hergestellten Bauteilen nach sich. Deshalb besteht der Bedarf nach einem verbesserten Ansatz.

Im Stand der Technik sind einige Veröffentlichungen in diese Richtung bekannt. Hierbei werden die EP 1925008 A1 und die US 2008/202258 A1 genannt. Die EP 1925008 A1 offenbart horizontal verschiebbare Permanentmagnete. Die US 2008/202258 A1 offenbart ein MEMS-System mit gegenüberliegenden Arrays mit Permanentmagneten, die als Schocksensor einen elektrischen Kontakt schließen.

Aufgabe der vorliegenden Erfindung ist es, ein Konzept zur Kraft- bzw. Bewegungsübertragung zu schaffen, das in Bezug auf den Verschleiß und die übertragbare Kraft optimiert ist.

Die Aufgabe wird durch die unabhängigen Patentansprüche gelöst.

Ausführungsbeispiele der vorliegenden Erfindung schaffen ein MEMS-System mit zumindest zwei permanentmagnetischen Mikrostrukturen. Die erste permanentmagnetische Mikrostruktur ist in eine erste Richtung (z. B. entlang der Substratebene) bewegbar. Die zweite permanentmagnetische Struktur ist gegenüber der ersten permanentmagnetischen Struktur beabstandet angeordnet und derart gelagert, so dass durch eine Bewegung der ersten permanentmagnetischen Mikrostruktur in die erste Richtung die zweite permanentmagnetische Mikrostruktur oder ein oder mehrere Elemente der zweiten permanentmagnetischen Mikrostruktur in die zweite Richtung betätigt werden (unter einer Betätigung ist im einfachsten Fall eine einfache Krafteinkopplung zu verstehen) oder bewegt. Alternativ wäre es auch denkbar, dass infolge der Bewegung eine Rotation der zweiten permanentmagnetischen Mikrostruktur bzw. von Elementen der permanentmagnetischen Mikrostruktur bewirkt wird.

An dieser Stelle sei angemerkt, dass entsprechend Ausführungsbeispielen unter einer permanentmagnetischen Struktur (erste und/oder zweite) sowohl eine Struktur mit nur einem Element (Einzelmagnet) als auch eine mit mehreren magnetischen Elementen (z.B. Fingern), die ein Magnet-Array formen verstanden wird. Also kann entsprechend einem Ausführungsbeispiel die erste permanentmagnetische Struktur eine Vielzahl von permanentmagnetischen Elementen (z.B. mehrere Magnet-Finger bzw. längliche Elemente oder auch eine zweidimensionale Anordnungen von würfelförmigen Magneten) umfassen, die zu einem Array angeordnet sind. Entsprechend einem weiteren Ausführungsbeispielen kann die zweite permanentmagnetische Struktur eine Vielzahl von permanentmagnetischen Elementen (z.B. mehrere Magnet-Finger bzw. längliche Elemente oder auch eine zweidimensionale Anordnungen von würfelförmigen Magneten) umfassen, die zu einem Array angeordnet sind. Hierbei kann das Array beispielsweise derart ausgeführt sein, dass die erste und/oder zweite permanentmagnetische Struktur als Art Kamm mit mehreren voneinander beabstandeten Elementen / Fingern geformt ist. Dieser Kamm kann entsprechend Ausführungsbeispielen ein Wiederholabstand der Einzelelemente von 10 bis 300 µm haben. Je nach Kopplung der permanentmagnetischen Elemente (starre Kopplung oder individuelle Kopplung) ist die Bewegung der permanentmagnetischen Mikrostruktur derart zu verstehen, dass eine Betätigung (im Sinne einer Kraftbeaufschlagung) oder eine Bewegung der gesamten zweiten permanentmagnetischen Mikrostruktur oder der einzelnen Elemente der zweiten permanentmagnetischen Mikrostruktur bewirkt wird. Bei dieser Bewegung kann es sich entweder um eine longitudinale Bewegung, z. B. senkrecht zu der Substratebene oder auch parallel zu der Substratebene (d. h. parallel zu der ersten Richtung) handeln oder um eine Rotation.

Ausführungsbeispiele der vorliegenden Erfindung liegt die Erkenntnis zugrunde, dass Mikrostrukturen mit miniaturisierten Permanentmagneten magnetisch miteinander gekoppelt werden können, so dass die Mikrostrukturen infolge einer Bewegung anderer Permanentmagneten, mit deren magnetischen Feld sie in Wechselwirkung treten, mit einer Kraft beaufschlagt oder ausgelenkt (im Sinne translatorisch oder rotorisch bewegt) werden. In anderen Worten ausgedrückt heißt das, dass die permanentmagnetischen Strukturen bzw. Elemente der permanentmagnetischen Strukturen aufgrund ihrer integrierten Mikromagnete eine Interaktion durchführen, um so durch die magnetische Kopplung eine kontaktfreie Übertragung von (möglichst hohen) Kräften (mit und ohne Bewegung), z. B. bis zu 100 µN oder bis zu 1 mN oder bis zu 10 mN oder sogar bis zu 500 mN, zu ermöglichen. Durch diese kontaktfreie Übertragung können insbesondere auch (größere) Distanzen (bis zu 100 µm oder bis zu 1 mm oder bis zu 5 mm oder bis zu 10 mm) innerhalb des mikromechanischen Bauelements/Systems überbrückt werden. Je nach genauer Implementierung kann eine gleich orientierte Bewegung der zwei permanentmagnetischen Mikrostrukturen oder eine Richtungsänderung bewirkt werden. Die Kraftkopplung ist kontaktlos. Es entstehen keine Verschleißeffekte an mechanischen Kontaktstellen, die im Fall von mikromechanischen Strukturen zu einem besonders schnellen Ausfall des Bauteils führen. Ein weiterer Vorteil ist, dass die Kraftkopplung mittels Permanentmagnete auf einem passiven Effekt beruht. Es muss also keine zusätzliche Energie aufgebracht werden, um diese Kraftkopplung aufrechtzuerhalten.

Entsprechend Ausführungsbeispielen können die permanentmagnetischen Elemente der magnetisch gekoppelten permanentmagnetischen Mikrostrukturen entweder durch anziehende Magnetkräfte (parallele Magnetisierung) (so dass sich entgegengesetzte Pole der zwei permanentmagnetischen Mikrostrukturen gegenüberliegen) oder durch abstoßende magnetische Kräfte (entgegengesetzte Magnetisierung, so dass immer gleiche Magnetpole der permanentmagnetischen Strukturen gegenüberliegen) erreicht werden. Alternativ kann auch eine vertikale Ausrichtung, d.h. also dass die Magnetisierungsrichtung der ersten permanentmagnetischen Mikrostruktur sich z. B. senkrecht (90° oder im Bereich von 80° bis 100°) erstreckt, vorliegen.

Gemäß Ausführungsbeispielen ist die erste permanentmagnetische Struktur bzw. deren Elemente mit einem mikromechanischen Aktor (Teil des MEMS-Systems) gekoppelt bzw. verbunden, wobei der mikromechanische Aktor ausgebildet ist, um die erste permanentmagnetische Struktur entlang der ersten Richtung zu bewegen. Der Aktor kann beispielsweise ein vertikal agierender Biegebalken sein, der in ein Substrat eingebettet ist. Entsprechend weiteren Ausführungsbeispielen sind die zwei permanentmagnetischen Strukturen innerhalb eines Substrats geformt. Hierbei kann sich z. B. die erste Richtung lateral entlang des Substrats erstrecken, während sich die zweite Richtung senkrecht zu dem Substrat oder auch lateral zu dem Substrat erstreckt. Selbstverständlich ist auch eine Orientierung um 90 Grad verdreht denkbar.

Gemäß Ausführungsbeispielen lassen sich also laterale Verschiebungen/Kräfte in vertikale Auslenkungen/Kräfte oder Kippbewegungen, aber auch vertikale Verschiebungen/Kräfte in laterale Auslenkungen/Kräfte übertragen. Dies ist insbesondere durch die der Mikrosystemtechnik zu Grunde liegende Planartechnologie von großer Bedeutung. Bei der Kombination einer entlang einer ersten Richtung bewegbaren Struktur mit einer entlang einer zweiten Richtung bewegbaren Struktur, wobei die zweite Richtung sich von der ersten Richtung unterscheidet, z. B. um 90 Grad, kann durch diese lateral-vertikale Kopplung im Fall von Arrays ein Faktor von ungefähr 2 zwischen der Eingangskraft und der resultierende Ausgangskraft erreicht werden. Insofern liegt ein Vorteil darin, dass hierbei auch eine Kraftübersetzung erfolgen kann.

Gemäß Ausführungsbeispielen können unterschiedliche Lagevarianten für die erste und die zweite permanentmagnetische Struktur bzw. die Elemente der ersten und zweiten permanentmagnetischen Strukturen vorgesehen sein. So ist es beispielsweise entsprechend einer ersten Variante möglich, dass die zweite permanentmagnetische Struktur bzw. deren Elemente so gelagert sind, dass diese sich nur noch um eine Rotationsachse (z. B. senkrecht zu der ersten Richtung) drehen können. Alternativ wäre es auch denkbar, dass die Lagerung so vorgesehen ist, dass die erste permanentmagnetische Struktur in einer Bewegung senkrecht zu der ersten Richtung eingeschränkt wird. Bezüglich der zweiten permanentmagnetischen Struktur sei angemerkt, dass diese bzw. deren Elemente entsprechend Ausführungsbeispielen in ihrer Bewegung senkrecht zu der zweiten Richtung eingeschränkt wird oder alternativ senkrecht zu der ersten Richtung eingeschränkt wird. Entsprechend bevorzugten Ausführungsbeispielen erstreckt sich sowohl die erste als auch die zweite permanentmagnetische Struktur bzw. deren Elemente entlang einer dritten Richtung, die zu der ersten und der zweiten Richtung senkrecht ist. Um noch einmal auf die Variante mit den rotierenden Elementen zurückzukommen, sei an dieser Stelle angemerkt, dass die Lagerung auch derart ausgerichtet sein kann, dass die Elemente bzw. die Struktur in ihrer Bewegung in der ersten, zweiten und dritten Richtung eingeschränkt wird, während eine Rotation, z. B. um einen Vektor, der sich entlang der dritten Richtung erstreckt, zugelassen wird.

Entsprechend Ausführungsbeispielen sind während der Bewegung der zwei Strukturen oder auch während des Ruhezustands die zwei permanentmagnetischen Strukturen voneinander beabstandet. Der Abstand wird über die Bewegung beibehalten, dadurch, dass sich die zwei permanentmagnetischen Strukturen entsprechend magnetisch gegenseitig beeinflussen. Entsprechend Ausführungsbeispielen ist der Abstand beispielsweise in einem Bereich von 1 µm bis 5 mm, bevorzugt zwischen 5 µm und 2000 µm oder besonders bevorzugt zwischen 10 und 1000 µm. Bezüglich der Dimensionierung der permanentmagnetischen Strukturen bzw. der einzelnen Elemente der permanentmagnetischen Strukturen, sei angemerkt, dass diese eine Kantenlänge zwischen 10 µm und 2 mm, bevorzugt zwischen 20 µm und 1000 µm oder besonders bevorzugt zwischen 30 µm und 800 µm haben können.

Wie oben bereits erwähnt, kann entsprechend Ausführungsbeispielen jede permanentmagnetische Struktur als Array ausgeführt sein, das heißt also eine Mehrzahl an Elementen umfassen. Die Verwendung von Arrays permanentmagnetischer Mikrostrukturen erlaubt es, die für die Kraftübertragung notwendige Verschiebung bei gleichzeitig hohen übertragenden Kräften zu minimieren. Also erlaubt die Verwendung von Arrays eine Kraftübertragung in der Fläche, wobei der Effekt von Form, Größe und Anordnung der Mikromagnete in den beteiligten Arrays abhängt.

Bezüglich der Kopplung der Vielzahl der permanentmagnetischen Elemente sei angemerkt, dass diese entweder starr oder derart individuell sein kann, dass die Elemente infolge einer Bewegung der ersten permanentmagnetischen Struktur entlang der zweiten Richtung gleichartig bewegt werden oder eine gleichartige Rotation erfahren. Alternativ wäre es natürlich auch denkbar, dass die permanentmagnetischen Elemente individuell gelagert sind, so dass die Vielzahl der permanentmagnetischen Elemente eine individuelle Bewegung in Reaktion auf die Bewegung der ersten permanentmagnetischen Struktur erfährt. Hierbei kann entweder eine individuelle Rotation und/oder eine individuelle Longitudinalbewegung und/oder eine individuelle Vertikalbewegung gemeint sein. Bezüglich der Elemente der permanentmagnetischen Struktur sei angemerkt, dass diese in jeder permanentmagnetischen Struktur entsprechend einem Ausführungsbeispiel eine gleiche Form aufweisen können oder entsprechend einem weiteren Ausführungsbeispiel auch unterschiedlich sein können. Entsprechend einem Ausführungsbeispiel umfasst die erste permanentmagnetische Struktur ein oder mehrere permanentmagnetische Elemente, während die zweite permanentmagnetische Struktur eine Vielzahl an permanentmagnetischen Elementen umfasst, die einander gegenüberliegen. Auch kann die erste permanentmagnetische Struktur entsprechend einem weiteren Ausführungsbeispiel eine Vielzahl umfassen, die der Vielzahl der permanentmagnetischen Elemente der zweiten Struktur gegenüberliegt. Vorzugsweise ist die Anzahl der Elemente der ersten und zweiten permanentmagnetischen Struktur gleich.

Da die permanentmagnetischen Strukturen voneinander beabstandet sind, wäre es denkbar, dass eine der zwei permanentmagnetischen Strukturen gegenüber der anderen der zwei permanentmagnetischen Strukturen gekapselt ist. Beispielsweise könnte die zweite permanentmagnetische Struktur in einer Kammer angeordnet sein. Dies ermöglicht, dass die Kammer mit einem speziellen Fluid oder Gas gefüllt werden kann oder evakuierbar ist.

Ein weiteres Ausführungsbeispiel bezieht sich auf ein Herstellungsverfahren des oben erläuterten MEMS-Systems. Das Herstellungsverfahren umfasst den zentralen Schritt der Agglomeration von Pulver mittels Atomlagenabscheidung oder mittels einer andersartigen Abscheidung, um die erste und/oder die zweite permanentmagnetische Struktur (z. B. in einem Substrat) zu formen, oder um die ein oder mehreren Elemente der ersten und/oder der zweiten permanentmagnetischen Struktur zu formen.

Weiterbildungen sind in den Unteransprüchen definiert. Ausführungsbeispiele der vorliegenden Erfindung werden anhand der beiliegenden Zeichnungen erläutert. Es zeigen:
- Fig. 1a-2b: schematische Darstellungen von konventionellen MEMS-Systemen, die mikromagnetische Elemente verwenden, zu Vergleichszwecken;
- Fig. 3: eine schematische Darstellung eines MEMS-Systems mit zwei permanentmagnetischen Mikrostrukturen gemäß einem Basis-Ausführungsbeispiel;
- Fig. 4: eine schematische Darstellung einer magnetischen Kopplung mittels zweier Arrays gemäß erweiterten Ausführungsbeispielen;
- Fig. 5: ein schematisches Diagramm zur Illustration des resultierenden Kraftverlaufs des Ausführungsbeispiels aus Fig. 4;
- Fig. 6a-6d: schematische Darstellungen zur Illustration der möglichen Kraftwirkrichtungen und Bewegungsrichtungen gemäß Ausführungsbeispielen;
- Fig. 7a-7b: schematische Darstellungen von möglichen Kraftwirkrichtungen und resultierenden Bewegungen gemäß Ausführungsbeispielen;
- Fig. 8: schematische Darstellungen von zwei als Array ausgeführten permanentmagnetischen Mikrostrukturen gemäß Ausführungsbeispielen;
- Fig. 9: eine schematische Darstellung von zwei als Array ausgeführten permanentmagnetischen Mikrostrukturen zur Illustration einer individuellen Kopplung gemäß weiteren Ausführungsbeispielen;
- Fig. 10: eine schematische Darstellung einer als Array ausgeführten permanentmagnetischen Struktur in Kombination mit einer als ein Element ausgeführten permanentmagnetischen Struktur gemäß weiteren Ausführungsbeispielen;
- Fig. 11: eine schematische Darstellung von zwei als Array ausgeführten permanentmagnetischen Strukturen zur Illustration einer gegenläufigen Magnetisierung gemäß Ausführungsbeispielen; und
- Fig. 12a-12b: eine schematische Darstellung von einer magnetischen Kraftkopplung innerhalb ein und desselben Mediums sowie in unterschiedlichen Medien gemäß weiteren Ausführungsbeispielen.

Bevor nachfolgend Ausführungsbeispiele der vorliegenden Erfindung anhand der beiliegenden Zeichnungen erläutert werden, sei darauf hingewiesen, dass gleichwirkende Elemente und Strukturen mit gleichen Bezugszeichen versehen sind, so dass die Beschreibung derer aufeinander anwendbar bzw. austauschbar ist.

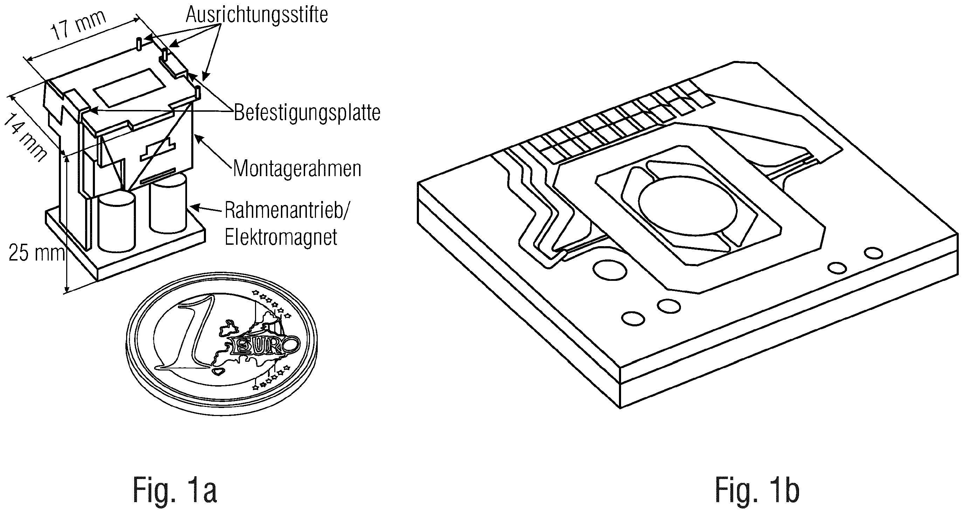

Wie oben bereits erläutert, basieren Ausführungsbeispiele darauf, dass mikromechanische Strukturen oder Elemente von mikromechanischen Strukturen magnetisch miteinander gekoppelt sind, so dass sie Kräfte von der einen mikromechanischen Struktur auf eine andere mikromechanische Struktur übertragen können und/oder sie sich in ihrer Bewegung gegenseitig beeinflussen. Da derartige Ausführungsbeispiele darauf basieren, dass mikromechanische Strukturen permanentmagnetisch ausgeführt sind, wird nachfolgend ein kurzer Überblick über die bereits im Einsatz befindlichen kontaktlosen magnetischen Kraftübertragungselemente gegeben. Im MEMS-System wurden bisher vor allem Hybrid-montierte bzw. externe Permanentmagnete in Kombination mit Spulen zur direkten Krafterzeugung verwendet [19, 20]. Solche Bauteile sind in Fig. 1a und 1b dargestellt.

Fig. 1a zeigt einen magnetisch betätigbaren Mikroscanner mit einem auf der Unterseite der beweglichen Spiegelstruktur aufgeklebten Permanentmagneten und externen Spulen (vgl. [19]). Fig. 1b zeigt einen magnetisch betätigbaren Mikroscanner mit einer auf der Oberseite der beweglichen Spiegel-Struktur integrierten Planarstruktur und einen externen, im Package befindlichen Permanentmagneten (vgl. [20]).

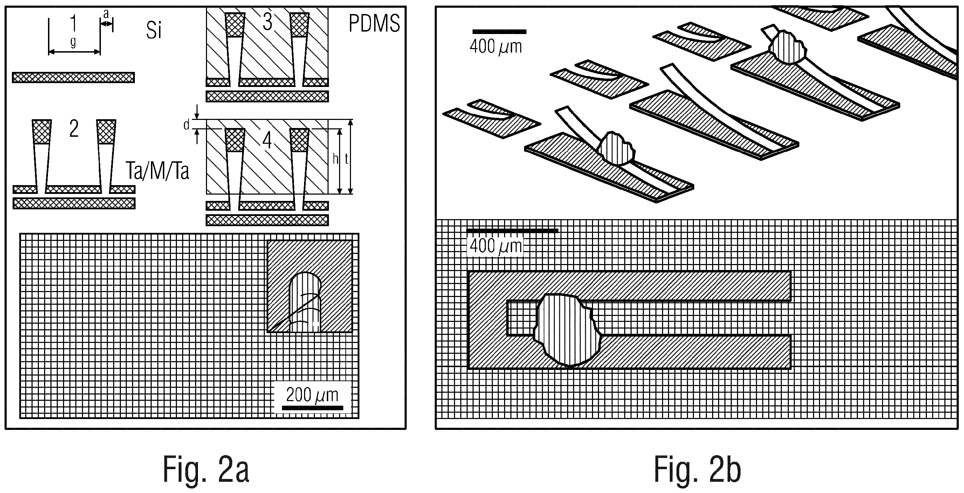

Da die magnetische Kraftwirkung mit dem Volumen skaliert, sind möglichst große Magnete von Vorteil. Ideal für MEMS wären Strukturen mit Kantenlängen von wenigen Zehn bis zu einigen Hundert Mikrometern. Typische Abscheideprozesse der Halbleitertechnologie sind jedoch für Schichten mit wenigen Mikrometern Dicke ausgelegt, so dass das Volumen so erzeugter Magnete sehr klein bleibt. Klassische Sinterverfahren eignen sich nur zur Herstellung deutlich größerer Strukturen. In letzter Zeit wurde daher verstärkt an Herstellungsverfahren für Mikromagnete "mit Volumen" gearbeitet. Zu erwähnen ist die Abscheidung dicker NdFeB-Schichten mittels Sputtern oder Pulsed Laser Deposition (PLD) [21]. Ein Problem ist die Strukturierung solcher Schichten. In [22] wird es durch Besputtern von Mikrosäulen mit NdFeB und deren anschließenden Transfer in eine flexible Polymermembran gelöst, siehe Fig. 1a. Mittels externer magnetischer Felder kann die Verwölbung solcher Membranen kontrolliert werden. Eine weitere Möglichkeit zur Herstellung von Mikromagneten ist die Verwendung von Pasten oder Lösungen aus Magnetpartikeln und Polymeren als Ausgangsmaterial. In [23] wird ein Stromsensor vorgestellt, bestehend aus einem einseitig eingespannten Biegebalken mit Piezowandler und einem mittels Dispersion einer NdFeB-Pulver-Epoxy-Lösung erzeugten Mikromagneten auf dem freien Ende, siehe Fig. 2b. Strukturen mit besser definierter Form können durch Einbringen eines Magnetpulver-Polymer-Komposits in Mikroformen erzeugt werden. Aufgrund der mit dem Pulveranteil zunehmenden Viskosität lassen sich kleinere Strukturen nicht reproduzierbar realisieren. Ein Ausweg ist das Befüllen der Mikroformen mit losem Magnetpulver und dessen anschließende Verfestigung. In [24] wird dafür eine Parylene-Schicht verwendet. Alle polymerbasierten Verfahren haben jedoch wesentliche Nachteile hinsichtlich der Integration in MEMS aufgrund der geringen thermischen Stabilität des organischen Matrix-Materials sowie des unzureichenden Schutzes der Magnetpartikel vor Korrosionseffekten.

Fig. 2a zeigt Mikromagnet-Arrays aus Si-Mikrosäulen mit aufgesputtertem NdFeB, transferiert in eine flexible Polymermembran [22]. Fig. 2b zeigt Stromsensoren, bestehend aus einem piezoelektrischen Biegebalken mit einem Mikromagneten auf dem frei beweglichen Ende, der durch Dispersion einer magnetpulverhaltigen Lösung hergestellt wurde [23].

Eine attraktive Alternative zu den bisher erwähnten Methoden beruht auf der Agglomeration von losem Pulver mittels Atomic Layer Deposition (ALD) [25]. Auf diese Weise konnten erstmals permanentmagnetische Mikrostrukturen mit Kantenlängen zwischen 50 µm und 2000 µm reproduzierbar und kompatibel zu MEMS-Fertigungsprozessen auf planaren Substraten erzeugt werden. In [26] ist ein piezoelektrischer Vibrations-Harvester mit einem Mikromagnet-Array am frei beweglichen Ende eines Biegebalkens beschrieben. Das Bauelement wird nicht nur durch Vibrationen oder Erschütterungen betätigt, sondern auch durch veränderliche Magnetfelder, verursacht z. B. durch einen sich bewegenden, externen Permanentmagneten. Dank dessen ist es erstmals möglich, mit einem MEMS-Bauelement Energie aus Drehbewegungen zu gewinnen. Eine Ausführung basierend auf konventionellen Magneten und Piezo-Aktuatoren wird in [27] offengelegt.

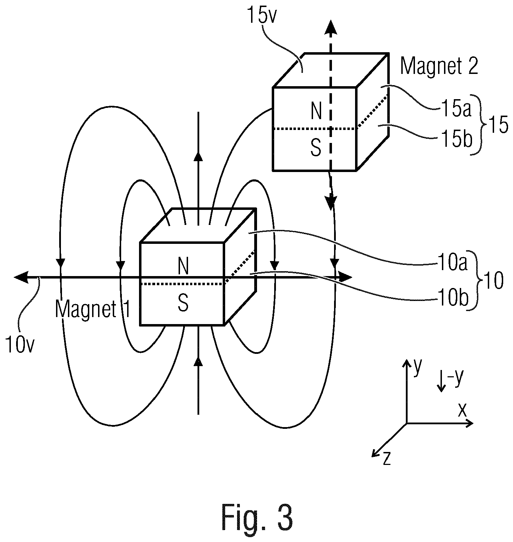

Ausgehend von dieser Situation kann durch das in Fig. 3 dargestellte Konzept eine Verbesserung geschaffen werden. Fig. 3 zeigt zwei permanentmagnetische Strukturen 10 und 15, die zu einem nicht weiter erläuterten MEMS-System gehören bzw. Bestandteil davon sind. Beispielsweise kann die permanentmagnetische Struktur 10 durch einen Aktor (nicht dargestellt) des MEMS-Systems bewegbar sein. Beide permanentmagnetische Strukturen umfassen hier in dem einfachsten Ausführungsbeispiel ein einzelnes permanentmagnetisches Element, nämlich hier das Element 10 bzw. 15. Beide Elemente 10 und 15 sind z. B. in einer Ebene bewegbar, die durch die zwei Bewegungsrichtungen 15v und 10v aufgespannt werden. Diese Ebene erstreckt sich in x-y-Richtung. Die Ausrichtung der Magnetisierung jeder der zwei permanentmagnetischen Elemente 15 und 10 ist mit den magnetischen Pole Nord und Süd gekennzeichnet, die hier mit dem Bezugszeichen 15a und 15b bzw. 10a und 10b markiert sind. Z. B. sind die Pole 15a und 15b sowie die Pole 10a und 10b so angeordnet, dass beide permanentmagnetischen Elemente eine positive Magnetisierung in y-Richtung aufweisen. Mit anderen Worten ausgedrückt heißt das, dass Nord- und Südpol 10a/10b des Elements 10 und Nord- und Südpol 15a und 15b des Elements 15 alle in derselben Ebene angeordnet sind. In diesem Ausführungsbeispiel ergibt sich, dass der Südpol 15b des Elements 15 dem Nordpol 10a des Elements 10 einander gegenüberliegt. Bei dieser Ausrichtung spricht man von einer parallelen Ausrichtung der Magnete 10 und 15.

Beide Elemente 10 und 15 sind bewegbar, wobei die Bewegbarkeit des Elements 10 derart eingeschränkt ist, dass dieses sich im Wesentlichen entlang des Vektors 10v (parallel zu x) bewegbar ist, während die Bewegung in y- und/oder z-Richtung eingeschränkt ist. Das Element 15 ist entlang des Vektors 15v bewegbar, der sich in y-Richtung erstreckt, wobei also eine Bewegung in z- und/oder x-Richtung eingeschränkt ist. Entsprechend Ausführungsbeispielen erfolgt diese Einschränkung durch eine Lagerung. Nachfolgend wird die Funktionsweise der hier dargestellten permanentmagnetischen Strukturen 10 und 15 erläutert. Die Verwendung permanentmagnetischer Mikrostrukturen 10 und 15 in MEMS ermöglicht die kontaktfreie Übertragung von Kräften, z. B. im Bereich von 1 µN bis 1 mN. Es wird beispielhaft davon ausgegangen, dass die permanentmagnetische Mikrostruktur 10, z.B. von einem in das MEMS-Bauelement integrierten Aktor entlang der Richtung 10v bewegt wird. Aufgrund des Magnetismus wird dann die permanentmagnetische Mikrostruktur 15 zu einer Bewegung angeregt. Diese erstreckt sich aufgrund von Magnetisierungsausrichtung und Lagerung entlang der Richtung 15v. Die Elemente der bzw. die Mikrostrukturen selbst interagieren kontaktlos, so dass Distanzen im Bereich von einigen Mikrometern bis mehreren Millimetern überbrückt werden können. Die genaue maximal übertragbare Kraft bzw. die maximal überbrückbare Strecke hängt im Wesentlichen von der Dimensionierung der Magneten 10 und 15 ab. Bei obigen Bereichen wurde beispielsweise davon ausgegangen, dass die einzelnen Magnete eine Kantenlänge im Bereich von 20 Mikrometer bis 500 Mikrometer haben bzw. Arrays aus derartigen permanentmagnetischen Elementen geformt sind. Je größer die zu übertragende Kraft ist bzw. je größer die zu überbrückende Distanz ist, umso größer werden im Regelfall die Magnete 10 und 15 dimensioniert.

Für die parallel magnetisierten, würfelförmigen Magnete in Fig. 3 ergibt sich in der dargestellten räumlichen Lage auf Magnet 15 eine starke Kraft in die negative x-Richtung sowie eine schwächere Kraft in die negative y-Richtung, zudem wirkt ein negatives Drehmoment um die z-Achse. Durch eine Verschiebung des Magneten 10 relativ zu Magnet 15 lassen sich die wirkenden Kräfte variieren. So wirkt z. B. bei Anordnung übereinander (gleiche Position auf der x-Achse) auf Magneten 15 keine Kraft in x-Richtung sowie eine stärkere Kraft in die negative y-Richtung. Auch das Drehmoment um die z-Achse verschwindet für diese Anordnung. Wie an diesem Beispiel gezeigt, lässt sich auf diese Weise z. B. durch eine relative laterale Verschiebung der beiden Magnete zueinander die vertikal wirkende Anziehungskraft sowie das übertragene Drehmoment variieren. Wie bereits erwähnt, skaliert die magnetische Kraftwirkung mit dem Volumen der beteiligten Magnete. Für pulverbasierte NdFeB-Mikromagnete ist gemäß [28] eine Magnetisierung von 500 mT gut erreichbar. Im Falle einer lateralen Verschiebung, wie in Fig. 3 gezeigt, ergibt sich bei einer Kantenlänge des Magneten von 50 µm und einen Abstand zwischen den Magneten von 50 µm eine maximale Anziehungskraft von 14 µN in y-Richtung. Für Magnete und Kantenlängen von 100 µm im Abstand von 50 µm beträgt die maximale Anziehungskraft in y-Richtung bereits 166 µN. Dieses Beispiel belegt, dass schon Permanentmagnete mit vergleichsweise kleinem Volumen die Übertragung erheblicher Kräfte über größere Distanzen ermöglichen.

Allerdings skaliert auch die, für eine maximale Modulation der Kraft notwendige Verschiebung mit deren Größe. Bei 50 µm Kantenlänge ist eine Verschiebung von mindestens 80 µm notwendig, bei 100 µm Kantenlänge eine Verschiebung von mindestens 135 µm. Die optimale Größe der Mikromagnete wird also auch durch die zur Verfügung stehende Verschiebung (vorgegeben durch den verwendeten Aktor) bestimmt. Um auch mit kleinen Magneten bzw. kleinen Verschiebungen möglichst große Kräfte übertragen zu können, bietet sich die Verwendung von Arrays aus permanentmagnetischen Mikrostrukturen an.

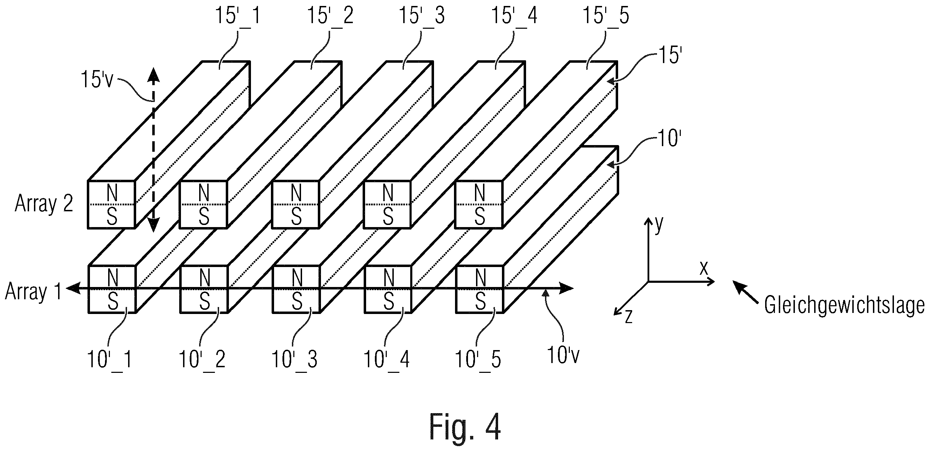

Ein Beispiel für eine solche Kombination ist in Fig. 4 gezeigt. Fig. 4 zeigt zwei aufeinander wirkende permanentmagnetische Strukturen 10' und 15'. Bei beiden permanentmagnetischen Strukturen handelt es sich um Arrays, die aus hier beispielsweise 5 kammförmig nebeneinander angeordneten Elementen 15'_1 bis 15'_5 bzw. 10'_1 bis 10'_5 implementiert sind. Die jeweils fünf Finger 10'_1 bis 10'_5 bzw. 15'_1 bis 15'_5 sind einander gegenüberliegend, wobei hier wiederum von einer parallelen Ausrichtung der Magnetisierung ausgegangen wird. Innerhalb jedes Arrays 10 und 15 ist die Ausrichtung aller Elemente 10'-'_1 bis 10'_5 bzw. 15'_1 bis 15'_5 gleich. Eine laterale Verschiebung (vgl. Vektor 10`v) des Arrays 10 kann genutzt werden, um die Kraftwirkung in y-Richtung (vgl. Vektor 15`v) zu modulieren. Durch die Array-Anordnung 10`/15` wird die Übertragung der Kraft erhöht, ohne dass eine größere Verschiebung des Arrays 10 notwendig ist. Eine Verlängerung der Mikromagnete in z-Richtung zu quaderförmigen Mikromagneten 10'_1 bis 10'_5 und 15'_1 bis 15'_5 (optionales Merkmal) bringt eine weitere Steigerung der Kraft ohne Auswirkung auf die verwendeten Verschiebungen zu haben.

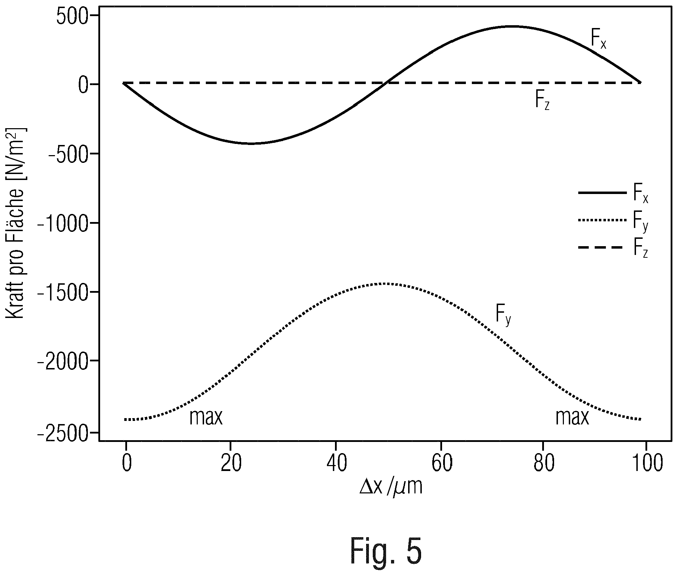

Das Ergebnis der numerischen Modulierung der Array-Anordnung 10'/15' aus Fig. 4 ist in Fig. 5 gezeigt. Für die Berechnungen wurden unendlich lange Magnetfinger mit quadratischem Querschnitt (50 µm Kantenlänge) angenommen, der Abstand der beiden Arrays 10'/15' wurde bei 50 µm gehalten. Unter Verwendung periodischer Randbedingungen wurde das Verhalten unendlicher Arrays simuliert, daher wurden die Kräfte auf die genutzte Array-Fläche normiert. Wie aus Fig. 5 ersichtlich, variieren die Kräfte auf Grund der Symmetrie periodisch mit der doppelten Kantenlänge der würfelförmigen Magneten. In der Gleichgewichtslage (Δx = 0) sind die Magneten 10'_1 bis 10'_5/15'_1 bis 15'_5 in y-Richtung zueinander ausgerichtet und es wirkt die maximale anziehende Kraft von 2420 N/m². Bei der Auslenkung des Arrays 15' aus dieser Gleichgewichtslage bis zu einer Verschiebung von Δx = 50 µm wirkt eine rückstellende Kraft in negative x-Richtung von bis zu 430 N/m². Die Anziehungskraft in y-Richtung nimmt durch diese Verschiebung ab, bis sie bei Δx = 50 µm ihren geringsten Wert von 1445 N/m² erreicht. Dies ist eine instabile Lage, da eine weitere Verschiebung in x-Richtung zu einer vorwärts treibenden Kraft in x-Richtung führt, die wiederum bis zu 430 N/m² erreicht. Bei einer Verschiebung von Δx = 100 µm ist die nächste stabile Lage erreicht, die der Gleichgewichtslage um eine Periode verschoben entspricht.

Entsprechend dieser Ergebnisse lässt sich somit mit einer lateralen Verschiebung von max. 50 µm und einer lateralen Kraft bis zu 430 N/m² eine vertikale Kraft um bis zu 975 N/m² modulieren. Es findet somit eine Verstärkung der Kraft um einen Faktor von ca. 2 statt. In der technischen Umsetzung kommt der Aufhängung und Führung der Arrays eine besondere Bedeutung zu. Während die Federsteifigkeit in Richtung lateraler Verschiebung klein zu wählen ist, um nicht unnötig hohe Kräfte aufbringen zu müssen, ist die vertikale Federsteifigkeit möglichst steif zu wählen, um nicht durch die Nachgiebigkeit des hier als fest angenommenen Arrays Kraft oder Auslenkung in vertikaler Richtung zu verlieren. Zudem muss ein Mitlaufen des nicht angetriebenen Arrays in die Antriebsrichtung verhindert werden.

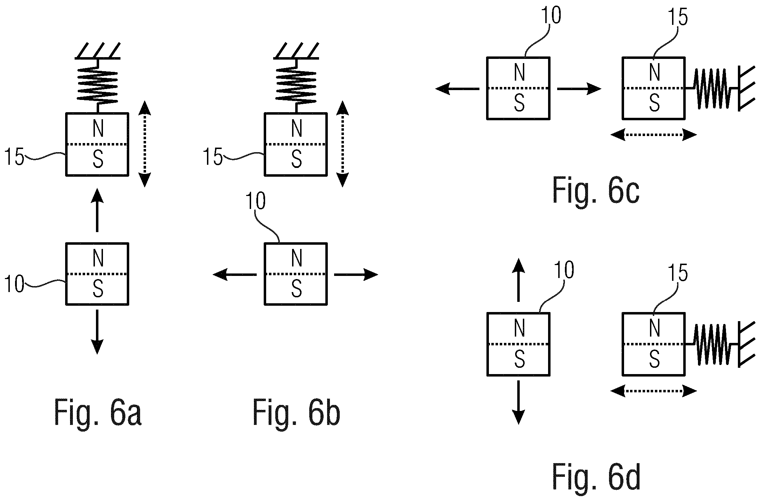

In den Figuren 6a-d sind jeweils unterschiedliche Lagerungen der permanentmagnetischen Strukturen 10 und 15 bzw. der einzelnen permanentmagnetischen Elemente der permanentmagnetischen Strukturen 10 und 15 dargestellt, um zu erläutern, welche linearen Verschiebungen (durchgezogener Pfeil) zu welchen linear wirkenden Kräften bzw. Auslenkungen resultieren (gestrichelter Pfeil).

In Fig. 6a und 6c wirken Eingangsverschiebung und Auslenkung bzw. Kraft jeweils parallel. Gezeigt sind die vertikal-vertikal-Kopplung (Fig. 6a) sowie die lateral-lateral-Kopplung (Fig. 6c). Im Gegensatz dazu wird in den in Fig. 6b und 6d gezeigten Geometrien die Auslenkung bzw. Kraft senkrecht zur Eingangsverschiebung genutzt, es kommt also zu einer Drehung der Wirkrichtung um 90°. Dies sind die lateral-vertikal-Kopplung (Fig. 6b) sowie die vertikallateral-Kopplung (Fig. 6d).

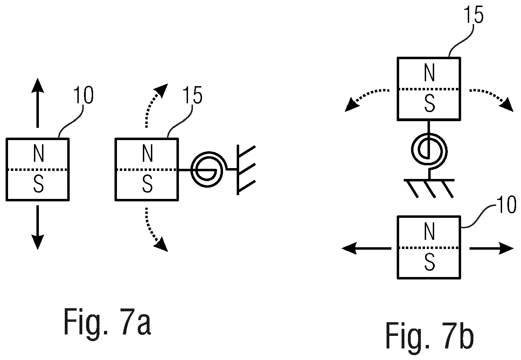

Unter Ausnutzung des übertragenden Drehmoments lassen sich weitere Geometrien zur Umwandlung einer linearen Bewegung der permanentmagnetischen Struktur 10 in eine Kippbewegung der permanenmagnetischen Struktur 15 finden. Beispiele hierfür sind in Fig. 7a und 7b gezeigt, wobei davon ausgegangen wird, dass das Element 10 translatorisch bewegbar ist, während das Element 15 rotorisch bewegbar ist. Die Geometrie in Fig. 7a wandelt eine vertikale Verschiebung des Elements 10 in eine Verkippung des Elements 15 um, während die Geometrie in Fig. 7b eine laterale Verschiebung des Elements 10 in eine Verkippung des Elements 15 transformiert. Besonders bei Fig. 7b ist zu erwähnen, dass die Lagerung beispielsweise zwischen den Elementen 10 und 15 angeordnet sein kann.

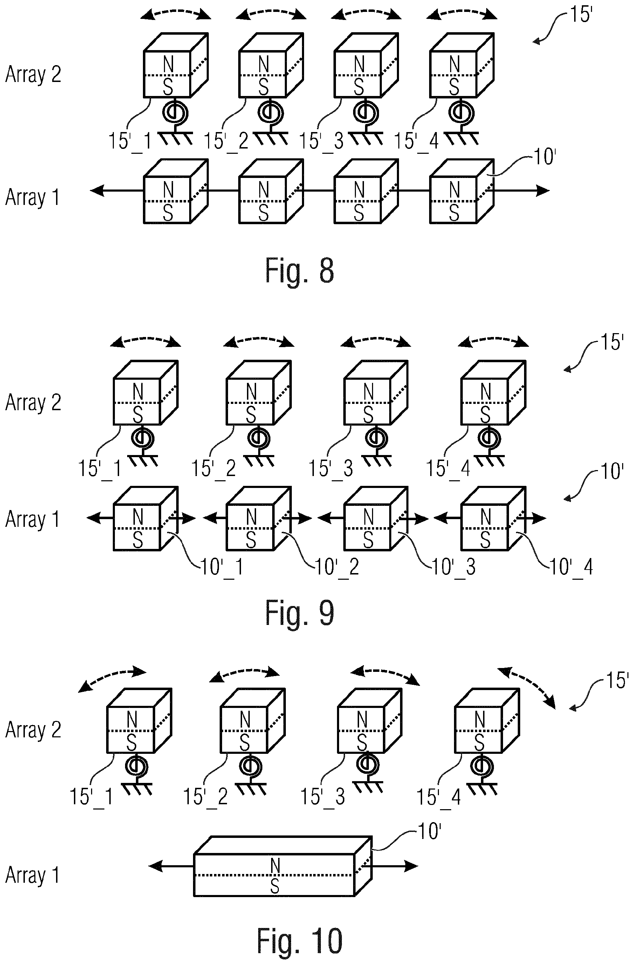

Bei den hier gezeigten Geometrien handelt es sich um Abstraktionen des Wirkungsprinzips zur Klassifizierung der möglichen Ausführungen der magnetischen Kraftkopplung. Die Magnete sind als Platzhalter für beliebig gestaltete permanentmagnetische Mikrostrukturen zu sehen. Neben Variationen in Form und Aspektverhältnis sind Ausführungen unter Verwendung von Mikromagnet-Arrays besonders vorteilhaft. Fig. 8, 9 und 10 illustrieren drei Beispiele. Die Arrays sind in Analogie zu Fig. 4 und Fig. 3 mit den Bezugszeichen 10' / 10 und 15' gekennzeichnet. Bei nachfolgender Betrachtung wird davon ausgegangen, dass immer das Array 10' (im Fall von Fig. 10 das Element 10`) translatorisch bewegt wird und zwar so, dass die einzelnen Elemente des Arrays 10' relativ zu den einzelnen Elementen des Arrays 15' verschoben werden. Die Elemente des Arrays 15' sind jeweils einzeln rotorisch/ individuell gelagert. Bei dem Array 10' aus Fig. 8 wird von einem Array mit starr verbundenen / zueinander fixierten Elementen ausgegangen(so dass eine synchrone Bewegung der Mikromagnete des Array 15' erreicht wird), wobei es sich bei dem Array 10' aus Fig. 9 um ein solches handelt, bei dem die die einzelnen Elemente unabhängig bewegbar sind (z.B. durch mehrere (externe) MEMS-Aktoren). Bei Fig. 10 weist das Array 10' einen Einzelmagneten mit vergrößertem Querschnitt auf. Dieser Einzelmagnet 10' ist ausgebildet, mit allen Elementen 15`_1 bis 15'_4 zu interagieren, z.B. indem er entlang aller Elementen 15'_1 bis 15'_4 bewegt wird. Im Gegensatz dazu kann bei den Ausführungsbeispielen aus Fig. 8 und 9 jeweils eine Zuordnung der Elemente des Arrays 10 mit den Elementen des Arrays 15 vorhanden sein (vgl. Fig. 9 10'_1 mit 15_1, 10'_2 mit 15'_2, 10'_3 mit 15`_3 und 10'_4 mit 15'_4).

In Fig. 8 verursacht eine Verschiebung des Arrays 10`, dessen Mikromagneten innerhalb des Arrays starr fixiert sind, eine synchrone Verkippung der Mikromagnete des Arrays 15`, dessen Mikromagnete nicht miteinander verbunden sind. Im Gegensatz dazu können die Mikromagnete von Array 10' in der in Fig. 9 gezeigten Ausführung individuell verschoben werden, was sich in einer dementsprechenden, individuellen Verkippung der Mikromagnete von Array 15' äußert.

In Fig. 10 sind die Strukturen 10' und 15' nicht identisch, was Anzahl, Größe und Anordnung der Mikromagnete angeht. Eine Verschiebung des Mikromagneten 10' resultiert in einer individuellen Verkippung der Mikromagnete des Arrays 15' entsprechend dem dreidimensionalen Verlauf des magnetischen Felds.

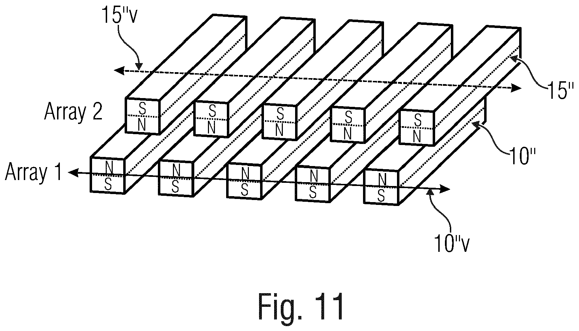

Die Ausführungen der magnetischen Kraftkopplung sind des Weiteren nicht auf eine parallele Magnetisierung der verwendeten magnetischen Strukturen 10`/15` bzw. 10/15 beschränkt. Für die in Fig. 6 und 7 abstrakt aufgeführten Kraftkopplungen lässt sich z. B. mit einer gegenläufigen Magnetisierung eine gegenläufige Bewegung realisieren. Insbesondere für die Array-Ausführung 10" bzw. 15" zur Kraftmodulation lässt sich eine gegenläufige Magnetisierung wie in Fig. 11 gezeigt ausnutzen, um die in Fig. 5 sichtbare überlagerte Anziehung durch eine überlagerte Abstoßung zu ersetzen. Dies ist insbesondere wichtig, wenn eine relativ weiche Feder für die vertikale Führung des Arrays 15/15'/15" verwendet wird, um hohe Auslenkungen zu erreichen. Eine überlagerte Anziehungskraft kann die rückstellende Federkraft überwiegen und die Magneten in den Kontakt ziehen. Durch die mit der gegenläufigen Magnetisierung verbundene Abstoßung ist eine solche Instabilität ausgeschlossen. Zu beachten ist, dass durch die gegenläufige Magnetisierung die Gleichgewichtslage bei einem Versatz von einer Kantenlänge vorliegt.

Entsprechend Ausführungsbeispielen ist die magnetische Kopplung nicht auf eine Übertragung der Kräfte durch freien Raum bzw. Umgebungsatmosphäre beschränkt, wie in den bisherigen Ausführungsbeispielen angenommen. Die meisten der in der Mikrosystemtechnik verwendeten Materialien haben eine vernachlässigbaren Einfluss auf das Magnetfeld. Hierdurch lässt sich der Vorteil der kontaktlosen Kraftübertragung weiter ausreizen, um Kräfte durch bestehende Strukturen zu übertragen, die z. B. eine kontaktmechanische Übertragung ausschließen.

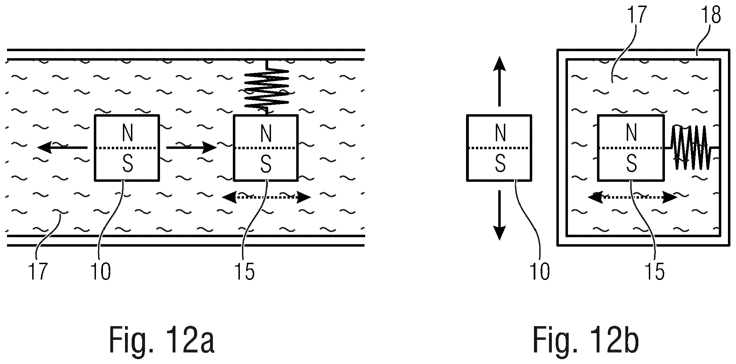

Ein derartiges Beispiel für die Kraftkopplung innerhalb eines Mediums 17 ist in Fig. 12a dargestellt. Von dem Bewegungsmuster (durchgezogener Pfeil Bewegung, z.B. bewirkt durch extern oder Aktor; gestrichelter Pfeil Reaktion) entspricht dieses hier dargestellte Ausführungsbeispiel dem Ausführungsbeispiel aus Fig. 6c.

Ein weiteres Beispiel für eine Übertragung einer Kraft oder eines mechanischen Signals von außen in ein abgeschlossenes System (vgl. Systemgrenze 18, innerhalb welchem ein Fluid oder eine Gasatmosphäre 17 (alternativ evakuierte Atmosphäre/Vakuum) vorherrschen kann) ist in Fig. 12b gezeigt. Also erlaubt die magnetische Kopplung eine Kraftübertragung durch die in der Mikrosystemtechnik verwendeten Materialien hindurch. Insofern lassen sich Kraftkopplungen im Fluid 17 oder durch hermetische Kapselungen 18 hindurch realisieren.

An dieser Stelle sei angemerkt, dass selbstverständlich die magnetische Kopplung nicht auf die Grenzen eines Bauteils beschränkt sind. Die beschriebenen Konzepte können auch zur kontaktlosen Übertragung von Kräften oder Verschiebungen zwischen verschiedenen Bauteilen verwendet werden. Einen Sonderfall bildet hierbei die Kopplung eines Mikrosystems mit einem makroskopischen Bauteil mittels permanentmagnetischen Strukturen zur Übertragung von Kräften oder Verschiebungen. Hierbei kommt wiederum die Übertragung durch bestehende Strukturmaterialien (die z. B. der Kapselung der Bauteile dienen, wie in Fig. 12b dargestellt (vgl. Kapselung 18)) zur Wirkung. Dies ermöglicht insbesondere die Anwendung makroskopischer Antriebe, um Mikrosysteme anzutreiben.

Ausführungsbeispiele können in einer Vielzahl von mikroelektromechanischen Systemen Anwendung finden, wo bisher Antriebs- oder Sensorkonzepte an ihre Grenzen stoßen. Durch die hier beschriebene Erfindung lassen sich Kraft- und Auslenkungsrichtung umleiten, und sich geometrische Restriktionen somit abschwächen. Insbesondere die Verwendung als Lateral-Vertikal-Wandler im lateral agierenden Antriebe zur Generierung von vertikalen Auslenkungen ist besonders vorteilhaft. Hiervon profitieren beispielsweise Anwendungen, die große vertikale Auslenkungen erfordern, wie z. B. Mikrospiegel und/oder Mikrolautsprecher.

Auch wenn bei obigen Ausführungsbeispielen immer von einer Bewegung des zweiten Arrays 10 infolge einer Bewegung des ersten Arrays 15 ausgegangen wurde, sei an dieser Stelle darauf hingewiesen, dass statt der Bewegung des zweiten Arrays 10 auch eine Betätigung im Sinne einer Krafteinkopplung erfolgen kann.

### Zitierte Dokumente

[1] R. Legtenberg et al., "Comb-drive actuators for large displacements", J. Micromech. and Microeng., Nr. 6, 1996
[2] A. P. Lee et al., "Electrostatic comb drive for vertical actuation", Proc. SPIE3224 Micromachined Devices and Components III, 1997
[3] D. Hah et al., "Theory and Experiments of Angular Vertical Com-Drive Actuators for Scanning Micromirrors", J. Selected Topics in Quantum Electronics, Nr. 10, 2004
[4] J. A. Yeh et al. "Large rotation actuated by in-plane rotary comb-drives with serpentine spring suspension", J. Micromech. and Microeng., Nr. 15, 2005
[5] J. E. Wong et al., "An electrostatically-actuated MEMS switch for power applications", Proc. IEEE MEMS Conf., Miyazaki, Japan, 2000
[6] X. M. Zhang et al., "A study of the static characteristics of a torsional micromirror", Sensors and Actuators A: Physical, Nr. 90, 2001
[7] J. D. Grade et al., "Design of Large Deflection Electrostatic Actuators", J. Microelectromech. Sys., Nr. 12, 2003
[8] N. Takeshima et al., "Electrostatic Parallelogram Actuators", Proc. IEEE Transducers Conf., San Francisco, CA, USA, 1991
[9] X. T. Huang et al., "A micromotion amplifier", Proc. IEEE MEMS Conf., San Diego, CA, USA, 1996
[10] G. Krishnan et al., "Evaluation and Design of Displacement-Amplifying Compliant Mechanisms for Sensor Aplications", J. Mechanical Design, Nr. 130, 2008
[11] I. Zeimpekis et al., "Characterization of a Mechanical Motion Amplifier Applied to a MEMS Accelerometer". J. Microelektromech. Sys., Nr. 21, 2012
[12] J.-C. Tsai et al., "Design, Fabrication, and Characterization of a High Fill-Factor, Large Scan-Angle. Two-Axis Scanner Array Driven by a Leverage Mechanism", J. Microelectromech. Sys., Nr. 15, 2006.
[13] M. S. Rodgers et al., "Designing and operating electrostatically driven microengines", University of North Texas Libraries, Albuquerque, 1998.
[14] C. T.-C. Nguyen, "Frequency-selective MEMS for miniaturized low-power communication devices" IEEE Transact5ions on Microwave Theory and Techniques, 1999.
[15] D. Weinstein et al., "Mechanical Coupling of 2D Resonator Arrays for MEMS Filter Applications", IEEE International Frequency Control Symposium, 2007.
[16] S. Pourkamali et al., "Electrically coupled MEMS bandpass filters Part II. Without coupling element", Sensors and Actuators A, Nr. 122, 2005
[17] H. Sasaki et al., "A force transmission system based on a tulip-shaped electrostatic clutch for haptic display devices",J. Micromech. and Microeng., Nr. 16, 2006.
[18] D. Isarakorn et al., "Energy scavenging from a rotating gear using an impact type piezoelectric energy scavenger", Patent Application WO 2012/164545 A1
[19] I. Aoyagi et al., " A raster-output 2D MEMS scanner with an 8x4 mm mirror for an automotive time-of-flight image sensor", Proc. IEEE Transducers Conf., Barcelona, Spain, 2013
[20] C. L. Arrasmith et al., "MEMS-based handheld confocal microscope for in-vitro skin imaging", Optics Express, Vol. 18, No. 4, 2010
[21] M. Nakano et al., "Magnetic properties of Pr-Fe-B thick-film magnets deposited on Si substrates with glass buffer layer", AIP Advances 8, 2018
[22] D. Le Roy et al., "Fabrication and characterization of polymer membranes with integrated arrays of high performance micro-magnets", Materials Today Communications, 6, 2016
[23] E. S. Leland et al., "A MEMS AC current sensor for residential and commercial electricity end-use monitoring",J. Micromech. and Microeng., 19, 2009
[24] O. D. Oniku et al., "High-energy-density permanent micromagnets formed from heterogeneous magnetic powder mixtures", Proc. IEEE MEMS Conf., Paris, France, 2012
[25] T. Lisec et al., "A Novel fabrication technique for MEMS based on agglomeration of powder by ALD", J. Microelectromech. Sys., Vol. 26, No. 5, 2017
[26] F. Lofink et al., "Magnetically driven energy-harvester with monolithically integrated high-energy-density magnets", Proc. IEEE Transducers Conf., Kaohsiung, Taiwan, 2017
[27] Offenlegungsschrift US 20140152134 A1, "Energy harvesting devices"
[28] T. Reimer et al., "Temperature-stable NdFeB micromagnets with high-energy density compatible with CMOS back end of line technology", MRS Advances, No. 1, 2016
[29] Offenlegungsschrift DE102016215616 A1, "Verfahren zum Herstellen einer magnetischen Struktur"

## Patentansprüche

1. MEMS-System, mit folgenden Merkmalen:
einer ersten permanentmagnetischen Mikrostruktur (10, 10', 10"), die entlang einer ersten Richtung (10v, 10'v, 10"v) bewegbar ist;
einer zweiten permanentmagnetischen Mikrostruktur (15, 15', 15"), die gegenüber der ersten permanentmagnetischen Mikrostruktur (10, 10', 10") beabstandet angeordnet ist, wobei durch eine Bewegung der ersten permanentmagnetischen Mikrostruktur (10, 10', 10") entlang der ersten Richtung (10v, 10'v, 10"v) die zweite permanentmagnetische Mikrostruktur (15, 15', 15") oder ein oder mehrere Elemente (15'_1, 15'_2, 15'_3, 15'_4, 15'_5) der zweiten permanentmagnetischen Mikrostruktur (15, 15', 15") entweder in eine zweite Richtung (15v, 15'v, 15"v) bewegt oder betätigt werden oder eine Rotation erfahren;
wobei die erste permanentmagnetische Mikrostruktur (10, 10', 10") durch ein erstes Array geformt ist, das eine Vielzahl von permanentmagnetischen Elementen (10'_1, 10'_2, 10'_3, 10'_4, 10'_5) umfasst; oder wobei die zweite permanentmagnetische Mikrostruktur (15, 15', 15") durch ein zweites Array geformt ist, das eine Vielzahl der permanentmagnetischen Elemente (15'_1, 15'_2, 15'_3, 15'_4, 15'_5) umfasst; und
wobei die Vielzahl der permanentmagnetischen Elemente (10'_1, 10'_2, 10'_3, 10'_4, 10'_5, 15'_1, 15'_2, 15'_3, 15'_4, 15'_5) des ersten oder des zweiten Arrays starr miteinander verbunden sind, sodass die zweite permanentmagnetische Mikrostruktur infolge einer Bewegung der ersten permanentmagnetischen Mikrostruktur (10, 10', 10") entlang der zweiten Richtung (15v, 15'v, 15"v) gleichartig bewegt oder betätigt wird oder eine Rotation erfährt.

2. MEMS-System gemäß Anspruch 1, wobei jedes Element des ersten oder des zweiten permanentmagnetischen Mikrostruktur (10, 10', 10", 15, 15', 15") eine Kantenlänge im Bereich von 10 µm bis 2 mm, bevorzugt im Bereich von 20 µm bis 1000 µm, besonders bevorzugt im Bereich von 30 µm bis 800 µm aufweist; und/oder wobei das jeweilige Array einen Wiederholabstand der Elemente im Bereich von 10 µm bis 4 mm, bevorzugt im Bereich von 20 µm bis 1500 µm, besonders bevorzugt im Bereich von 50 µm 1000 µm aufweist.

3. MEMS-System gemäß einem der vorherigen Ansprüche, wobei die erste (10, 10', 10") und die zweite permanentmagnetische Mikrostruktur (15, 15', 15") derart konfiguriert sind, dass über einen gesamten Bewegungsbereich der ersten (10, 10', 10") und zweiten permanentmagnetischen Struktur (15, 15', 15") ein Abstand in einem Bereich von 1 µm bis 5 mm oder in einem Bereich von 5 µm bis 2000 µm oder in einem Bereich von 10 µm bis 1000 µm ist.

4. MEMS-System gemäß einem der vorherigen Ansprüche, wobei die erste permanentmagnetische Mikrostruktur (10, 10', 10") gegenüber der zweiten permanentmagnetischen Mikrostruktur (15, 15', 15") parallel magnetisiert ist oder gegenläufig magnetisiert ist.

5. MEMS-System gemäß einem der Ansprüche 1 bis 5, wobei die zweite Richtung sich von der ersten Richtung unterscheidet; oder wobei die zweite Richtung (15v, 15'v, 15"v) senkrecht zu der ersten Richtung (10v, 10'v, 10"v) verläuft.

6. MEMS-System gemäß einem der vorherigen Ansprüche, wobei die zweite permanentmagnetische Mikrostruktur (15, 15', 15") oder das eine oder die mehreren Elemente (15'_1, 15'_2, 15'_3, 15'_4, 15'_5) der zweiten permanentmagnetischen Mikrostruktur (15, 15', 15"), die das zweite Array formen, um jeweils eine Rotationsachse rotiert werden, die senkrecht zu der ersten Richtung (10v, 10'v, 10"v) verläuft.

7. MEMS-System gemäß einem der vorherigen Ansprüche, wobei das MEMS-System eine Lagerung für die erste permanentmagnetische Struktur (10, 10', 10") aufweist, die eine Bewegung oder Betätigung senkrecht zu der ersten Richtung (10v, 10'v, 10"v) einschränkt.

8. MEMS-System gemäß einem der vorherigen Ansprüche, wobei die zweite permanentmagnetische Mikrostruktur (15, 15', 15") oder die ein oder mehreren Elemente (15'_1, 15'_2, 15'_3, 15'_4, 15'_5) der zweiten permanentmagnetischen Mikrostruktur (15, 15', 15") mittels einer Lagerung gelagert sind, die eine Bewegung oder Betätigung senkrecht zu der zweiten Richtung einschränkt oder die nur eine Rotation um einen durch die zweite permanentmagnetische Mikrostruktur (15, 15', 15") definierten Rotationspunkt oder definierte Rotationspunkte zulässt.

9. MEMS-System gemäß einem der Ansprüche 1 bis 8, wobei die Vielzahl der permanentmagnetischen Elemente (10'_1, 10'_2, 10'_3, 10'_4, 10'_5, 15'_1, 15'_2, 15'_3, 15'_4, 15'_5) derart individuell gelagert ist, dass sie infolge einer Bewegung der ersten permanentmagnetischen Mikrostruktur (10, 10', 10") entlang der zweiten Richtung (15v, 15'v, 15"v) gleichartig bewegt oder betätigt werden oder eine gleichartige Rotation erfahren.

10. MEMS-System gemäß einem der Ansprüche 1 bis 9, wobei die Vielzahl der permanentmagnetischen Elemente (10'_1, 10'_2, 10'_3, 10'_4, 10'_5, 15'_1, 15'_2, 15'_3, 15'_4, 15'_5) individuell gelagert ist, so dass die Vielzahl der permanentmagnetischen Elemente eine individuelle Bewegung oder Betätigung in Reaktion auf die Bewegung der ersten permanentmagnetischen Struktur (10, 10', 10") erfahren.

11. MEMS-System gemäß einem der vorherigen Ansprüche, das ferner einen mikromechanischen Aktor umfasst, der mit der ersten permanentmagnetischen Struktur (10, 10', 10") verbunden oder gekoppelt ist, wobei der mikromechanische Aktor ausgebildet ist, um die erste permanentmagnetische Struktur (10, 10', 10") entlang der ersten Richtung (10v, 10'v, 10"v) zu bewegen.

12. MEMS-System gemäß einem der vorherigen Ansprüche, wobei die erste permanentmagnetische Mikrostruktur (10, 10', 10") und die zweite permanentmagnetische Mikrostruktur (15, 15', 15") innerhalb eines Substrats geformt sind.

13. MEMS-System gemäß Anspruch 12, wobei sich die erste Richtung (10v, 10'v, 10"v) lateral entlang des Substrats erstreckt; und wobei sich die zweite Richtung (15v, 15'v, 15"v) lateral entlang des Substrats oder senkrecht zum Substrat erstreckt.

14. MEMS-System gemäß einem der folgenden Ansprüche, wobei die erste (10, 10', 10") oder zweite permanentmagnetische Mikrostruktur (15, 15', 15") in einer Kammer (18) angeordnet ist, so dass die erste permanentmagnetische Mikrostruktur (10, 10', 10") gegenüber der zweiten permanentmagnetischen Mikrostruktur (15, 15', 15") gekapselt ist.

15. Verfahren zur Herstellung eines MEMS-Systems gemäß einem der vorherigen Ansprüche, mit folgenden Schritten:
Agglomeration von Pulver mittels Atomlagenabscheidung oder mittels Abscheidung, um die erste (10, 10', 10") und/oder die zweite permanentmagnetische Mikrostruktur (15, 15', 15") zu formen oder um die ein oder mehreren Elemente der ersten und/oder der zweiten permanentmagnetischen Mikrostruktur (15, 15', 15") zu formen.

## Claims

1. A MEMS system, comprising:
a first permanent-magnetic microstructure (10, 10', 10") movable along a first direction (10v, 10'v, 10"v);
a second permanent-magnetic microstructure (15, 15', 15") arranged to be spaced apart from the first permanent-magnetic microstructure (10, 10', 10"), wherein, by moving the first permanent-magnetic microstructure (10, 10', 10") along the first direction (10v, 10'v, 10"v), the second permanent-magnetic microstructure (15, 15', 15") or one or more elements (15'_1, 15'_2, 15'_3, 15'_4, 15'_5) of the second permanent-magnetic microstructure (15, 15', 15") are either moved or actuated in a second direction (15v, 15'v, 15"v) or undergo rotation;
wherein the first permanent-magnetic microstructure (10, 10', 10") is formed by a first array comprising a plurality of permanent-magnetic elements (10'_1, 10'_2, 10'_3, 10'_4, 10'_5); or wherein the second permanent-magnetic microstructure (15, 15', 15") is formed by a second array comprising a plurality of the permanent-magnetic elements (15'_1, 15'_2, 15'_3, 15'_4, 15'_5); and
wherein the plurality of the permanent-magnetic elements (10'_1, 10_2, 10'_3, 10'_4, 10'_5, 15'_1, 15'_2, 15'_3, 15'_4, 15'_5) of the first or second array are rigidly connected to one another so that they are similarly moved or actuated as a result of a movement of the first permanent-magnetic microstructure (10, 10', 10") along the second direction (15v, 15'v, 15"v).

2. The MEMS system according to claim 1, wherein each element of the first or the second permanent-magnetic microstructure (10, 10', 10", 15, 15', 15") has an edge length in the range of 10 µm to 2 mm, preferably in the range of 20 µm to 1000 µm, particularly preferably in the range of 30 µm to 800 µm; and/or
wherein the respective array has a repeat spacing of the elements in the range of 10 µm to 4 mm, preferably in the range of 20 µm to 1500 µm, particularly preferably in the range of 50 µm 1000 µm.

3. The MEMS system according to any one of the preceding claims, wherein the first (10, 10', 10") and second permanent-magnetic microstructures (15, 15', 15") are configured such that, over an entire range of motion of the first (10, 10', 10") and second permanent-magnetic structures (15, 15', 15"), a spacing is in a range of 1 µm to 5 mm or in a range of 5 µm to 2000 µm or in a range of 10 µm to 1000 µm.

4. The MEMS system according to any one of the preceding claims, wherein the first permanent-magnetic microstructure (10, 10', 10") is magnetized in parallel with or is magnetized in opposite direction to the second permanent-magnetic microstructure (15, 15', 15").

5. The MEMS system according to any one of claims 1 to 5, wherein the second direction is different from the first direction; or wherein the second direction (15v, 15'v, 15"v) is perpendicular to the first direction (10v, 10'v, 10"v).

6. The MEMS system according to any one of the preceding claims, wherein the second permanent-magnetic microstructure (15, 15', 15") or the one or more elements (15'_1, 15'_2, 15'_3, 15'_4, 15'_5) of the second permanent-magnetic microstructure (15, 15', 15") forming the second array are each rotated about an axis of rotation that is perpendicular to the first direction (10v, 10'v, 10"v).

7. The MEMS system according to any one of the preceding claims, wherein the MEMS system comprises a support for the first permanent-magnetic structure (10, 10', 10") that restricts movement or actuation perpendicular to the first direction (10v, 10'v, 10"v).

8. The MEMS system according to any one of the preceding claims, wherein the second permanent-magnetic microstructure (15, 15', 15") or the one or more elements (15'_1, 15'_2, 15'_3, 15'_4, 15'_5) of the second permanent-magnetic microstructure (15, 15', 15") are supported by means of a support which restricts movement or actuation perpendicular to the second direction or which only permits rotation about a rotation point or points defined by the second permanent-magnetic microstructure (15, 15', 15").

9. The MEMS system according to any one of claims 1 to 8, wherein the plurality of permanent-magnetic elements (10'_1, 10'_2, 10'_3, 10'_4, 10'_5, 15'_1, 15'_2, 15'_3, 15'_4, 15'_5) are individually supported such that they are similarly moved or actuated or undergo a similar rotation as a result of a movement of the first permanent-magnetic microstructure (10, 10', 10") along the second direction (15v, 15'v, 15"v).

10. The MEMS system according to any one of claims 1 to 9, wherein the plurality of permanent-magnetic elements (10'_1, 10'_2, 10'_3, 10'_4, 10'_5, 15'_1, 15'_2, 15'_3, 15'_4, 15'_5) are individually supported such that the plurality of permanent-magnetic elements undergo individual movement or actuation in response to the movement of the first permanent-magnetic structure (10, 10', 10").

11. The MEMS system according to any one of the preceding claims, further comprising a micromechanical actuator connected or coupled to the first permanent-magnetic structure (10, 10', 10"), wherein the micromechanical actuator is configured to move the first permanent-magnetic structure (10, 10', 10") along the first direction (10v, 10'v, 10"v).

12. The MEMS system according to any one of the preceding claims, wherein the first permanent-magnetic microstructure (10, 10', 10") and the second permanent-magnetic microstructure (15, 15', 15") are formed within a substrate.

13. The MEMS system according to claim 12, wherein the first direction (10v, 10'v, 10"v) extends laterally along the substrate; and wherein the second direction (15v, 15'v, 15"v) extends laterally along the substrate or perpendicular to the substrate.

14. The MEMS system according to any one of the following claims, wherein the first (10, 10', 10") or second permanent-magnetic microstructure (15, 15', 15") is arranged in a chamber (18) such that the first permanent-magnetic microstructure (10, 10', 10") is encapsulated with respect to the second permanent-magnetic microstructure (15, 15', 15").

15. A method of manufacturing a MEMS system according to any one of the preceding claims, comprising the steps of:
agglomeration of powder by means of atomic layer deposition or by means of deposition to form the first (10, 10', 10") and/or the second permanent-magnetic microstructure (15, 15', 15") or to form the one or more elements of the first and/or the second permanent-magnetic microstructure (15, 15', 15").

## Revendications

1. Microsystème électromécanique, aux caractéristiques suivantes:
une première microstructure à aimant permanent (10, 10', 10") qui peut se déplacer dans une première direction (10v, 10'v, 10"v);
une deuxième microstructure à aimant permanent (15, 15', 15") qui est disposée distante de la première microstructure à aimant permanent (10, 10', 10"), où par un mouvement de la première microstructure à aimant permanent (10, 10', 10") dans la première direction (10v, 10'v, 10"v) sont soit déplacés ou actionnés dans une deuxième direction (15v, 15'v, 15"v), soit subissent une rotation la deuxième microstructure à aimant permanent (15, 15', 15") ou un ou plusieurs éléments (15'_1, 15'_2, 15'_3, 15'_4, 15'_5) de la deuxième microstructure à aimant permanent (15, 15', 15");
dans lequel la première microstructure à aimant permanent (10, 10', 10") est formée par un premier réseau qui comporte une pluralité d'éléments à aimant permanent (10'_1, 10'_2, 10'_3, 10'_4, 10'_5); ou dans lequel la deuxième microstructure à aimant permanent (15, 15', 15") est formée par un deuxième réseau qui comporte une pluralité d'éléments à aimant permanent (15'_1, 15'_2, 15'_3, 15'_4, 15'_5); et
dans lequel la pluralité d'éléments à aimant permanent (10'_1, 10'_2, 10'_3, 10'_4, 10'_5, 15'_1, 15'_2, 15'_3, 15'_4, 15'_5) du premier ou du deuxième réseau sont connectés rigidement l'un à l'autre, de sorte que la deuxième microstructure à aimant permanent (10, 10', 10") soit déplacée ou actionnée de la même manière ou subisse une rotation par suite d'un mouvement de la première microstructure à aimant permanent (10, 10', 10") dans la deuxième direction (15v, 15'v, 15"v).

2. Microsystème électromécanique selon la revendication 1, dans lequel chaque élément de la première ou de la deuxième microstructure à aimant permanent (10, 10', 10", 15, 15', 15") présente une longueur de côté de l'ordre de 10 µm à 2 mm, de préférence de l'ordre de 20 µm à 1000 µm, particulièrement de préférence de l'ordre de 30 µm à 800 µm; et/ou
dans lequel le réseau respectif présente une distance répétée des éléments de l'ordre de 10 µm à 4 mm, de préférence de l'ordre de 20 µm à 1500 µm, particulièrement de préférence de l'ordre de 50 µm à 1000 µm.

3. Microsystème électromécanique selon l'une des revendications précédentes, dans lequel la première (10, 10', 10") et la deuxième microstructure à aimant permanent (15, 15', 15") sont configurées de sorte que sur toute une plage de mouvement de la première (10, 10', 10") et de la deuxième microstructure à aimant permanent (15, 15', 15") existe une distance de l'ordre de 1 µm à 5 mm ou de l'ordre de 5 µm à 2000 µm ou de l'ordre de 10 µm à 1000 µm.

4. Microsystème électromécanique selon l'une des revendications précédentes, dans lequel la première microstructure à aimant permanent (10, 10', 10") est aimantée en parallèle ou aimantée en direction opposée par rapport à la deuxième microstructure à aimant permanent (15, 15', 15").

5. Microsystème électromécanique selon l'une des revendications 1 à 5, dans lequel la deuxième direction est différente de la première direction; ou dans lequel la deuxième direction (15v, 15'v, 15"v) est perpendiculaire à la première direction (10v, 10'v, 10"v).

6. Microsystème électromécanique selon l'une des revendications précédentes, dans lequel la deuxième microstructure à aimant permanent (15, 15', 15") ou l'un ou les plusieurs éléments (15'_1, 15'_2, 15'_3, 15'_4, 15'_5) de la deuxième microstructure à aimant permanent (15, 15', 15") qui forment le deuxième réseau sont, chacun, entraînés en rotation autour d'un axe de rotation qui s'étend de manière perpendiculaire à la première direction (10v, 10'v, 10"v).

7. Microsystème électromécanique selon l'une des revendications précédentes, dans lequel le microsystème électromécanique présente un support pour la première structure à aimant permanent (10, 10', 10") qui limite un mouvement ou un actionnement de manière perpendiculaire à la première direction (10v, 10'v, 10"v).

8. Microsystème électromécanique selon l'une des revendications précédentes, dans lequel la deuxième microstructure à aimant permanent (15, 15', 15") ou les un ou plusieurs éléments (15'_1, 15'_2, 15'_3, 15'_4, 15'_5) de la deuxième microstructure à aimant permanent (15, 15', 15") sont montés au moyen d'un support qui limite le mouvement ou l'actionnement de manière perpendiculaire à la deuxième direction ou qui ne permet qu'une rotation autour d'un point de rotation défini ou de points de rotation définis par la deuxième microstructure à aimant permanent (15, 15', 15").

9. Microsystème électromécanique selon l'une des revendications 1 à 8, dans lequel la pluralité d'éléments à aimant permanent (10'_1, 10'_2, 10'_3, 10'_4, 10'_5, 15'_1, 15'_2, 15'_3, 15'_4, 15'_5) sont montés individuellement de sorte qu'ils soient, du fait d'un mouvement de la première microstructure à aimant permanent (10, 10', 10") dans la deuxième direction (15v, 15'v, 15"v), déplacés ou actionnés de la même manière ou subissent une rotation similaire.

10. Microsystème électromécanique selon l'une des revendications 1 à 9, dans lequel la pluralité d'éléments à aimant permanent (10'_1, 10'_2, 10'_3, 10'_4, 10'_5, 15'_1, 15'_2, 15'_3, 15'_4, 15'_5) sont montés individuellement de sorte que la pluralité d'éléments à aimant permanent subissent un mouvement ou un actionnement individuel en réaction au mouvement de la première structure à aimant permanent (10, 10', 10").

11. Microsystème électromécanique selon l'une des revendications précédentes, qui comporte par ailleurs un actionneur micromécanique qui est connecté ou couplé à la première structure à aimant permanent (10, 10', 10"), dans lequel l'actionneur micromécanique est conçu pour déplacer la première structure à aimant permanent (10, 10', 10") dans la première direction (10v, 10'v, 10"v).

12. Microsystème électromécanique selon l'une des revendications précédentes, dans lequel la première microstructure à aimant permanent (10, 10', 10") et la deuxième microstructure à aimant permanent (15, 15', 15") sont formées dans un substrat.

13. Microsystème électromécanique selon la revendication 12, dans lequel la première direction (10v, 10'v, 10"v) s'étend latéralement le long du substrat; et dans lequel la deuxième direction (15v, 15'v, 15"v) s'étend latéralement le long du substrat ou de manière perpendiculaire au substrat.

14. Microsystème électromécanique selon l'une des revendications suivantes, dans lequel la première (10, 10', 10") ou deuxième microstructure à aimant permanent (15, 15', 15") est disposée dans une chambre (18), de sorte que la première microstructure à aimant permanent (10, 10', 10") soit encapsulée par rapport à la deuxième microstructure à aimant permanent (15, 15', 15").

15. Procédé permettant de réaliser un microsystème électromécanique selon l'une des revendications précédentes, aux étapes suivantes:
agglomération de poudre par dépôt de couche atomique ou par dépôt pour former la première (10, 10', 10") et/ou la deuxième microstructure à aimant permanent (15, 15', 15") ou pour former les un ou plusieurs éléments de la première et/ou de la deuxième microstructure à aimant permanent (15, 15', 15").
